# EUROPEAN PATENT SPECIFICATION

(11) **EP 4 113 580 B1**
(45) Date of publication and mention of the grant of the patent: **31.12.2025**
(21) Application number: 21780127.3
(22) Date of filing: 04.03.2021
(51) Int. Cl.: H10D 30/47, H10D 62/17, H01L 21/20, H10D 62/85

(54) **SEMICONDUCTOR EPITAXIAL STRUCTURE AND SEMICONDUCTOR DEVICE**
HALBLEITER-EPITAXIALSTRUKTUR UND HALBLEITERBAUELEMENT
STRUCTURE ÉPITAXIALE SEMI-CONDUCTRICE ET DISPOSITIF À SEMI-CONDUCTEUR

(30) Priority: 31.03.2020 CN 202010241496
(43) Date of publication of application: 04.01.2023
(73) Proprietor: Huawei Technologies Co., Ltd., Shenzhen, Guangdong 518129, (CN)
(72) Inventor: CHEN, Zhibin, Shenzhen, Guangdong 518129 (CN)
(74) Representative: Gill Jennings & Every LLP
(86) International application number: PCT/CN2021/079157
(87) International publication number: WO 2021/196974

(56) References cited:
- EP-A1- 3 605 595
- CN-A- 106 449 914
- CN-A- 108 511 522
- CN-A- 109 952 655
- CN-A- 111 477 536
- US-A1- 2012 074 427
- US-A1- 2014 008 615
- US-A1- 2014 264 441
- US-A1- 2016 322 225
- SUN WEI ET AL: "III-Nitride Digital Alloy: Electronics and Optoelectronics Properties of the InN/GaN Ultra-Short Period Superlattice Nanostructures", SCIENTIFIC REPORTS, vol. 7, no. 1, 27 July 2017 (2017-07-27), US, pages 1 - 8, XP093270776, ISSN: 2045-2322, Retrieved from the Internet <URL:https://www.nature.com/articles/s41598-017-06889-3.pdf> DOI: 10.1038/s41598-017-06889-3

## Description

### TECHNICAL FIELD

This application relates to the field of semiconductor technologies, and in particular, to a semiconductor epitaxial structure and a semiconductor device.

### BACKGROUND

Gallium nitride (GaN) is widely used in a power electronic device, a radio frequency device, and the like because of advantages such as a wide band gap and high mobility. The gallium nitride is most widely used in a high electron mobility transistor (HEMT) field. A current enhanced HEMT includes a channel layer, a barrier layer, and a p-GaN layer that are sequentially laminated, and the p-GaN layer is generally implemented by doping Mg ions. However, Mg ions have a diffusion problem. When Mg ions massively diffuse to the barrier layer and the channel layer, density and mobility of two-dimensional electron gas (2DEG) may be affected, thereby causing an increase in on resistance.

US 2016/322225 A1 discloses a tructure and method of forming a GaN film on a Si substrate that includes an additional or second high temperature (HT) AlN seed layer, introduced for reducing the tensile stress of GaN on a Si substrate.

US 2012/074427 A1 a crack-free monocrystalline nitride layer having the composition AlxGa1-xN, where 0 ≦ x ≦ 0.3, and a substrate that is likely to generate tensile stress in the nitride layer.

Sun Wei ET AL: "Ill-Nitride Digital Alloy: Electronics and Optoelectronics Properties of the InN/GaN Ultra-Short Period Superlattice Nanostructures", Scientific Reports, vol. 7, no. 1, 27 July 2017, pages 1-8 discloses numerical studies on an InGaN digital alloy showing the tunable optoelectronic properties of the III-Nitride digital alloy.

### SUMMARY

A semiconductor epitaxial structure provided in this application effectively avoids a problem that Mg ions in a p-GaN layer diffuse to a barrier layer and a channel layer, which affects density and mobility of 2DEG, and causes a problem of an increase in on resistance.

A semiconductor device is further provided in this application.

The semiconductor epitaxial structure of the present invention is specified in appended claim 1. Further implementations are set out in the appended dependent claims.

In this application, the composite barrier layer is disposed between the doping layer and the channel layer, and the digital alloy barrier layer in the composite barrier layer includes one or more AlN layers, and is a laminated atomic layer formed by a compound. In other words, in this application, the digital alloy barrier layer that includes one or more AlN layers is disposed between the doping layer and the channel layer, which can effectively prevent Mg ions doped in the doping layer from diffusing to the composite barrier layer and the channel layer, thereby avoiding an increase in the on resistance, and ensuring electrical performance of the semiconductor epitaxial structure. In addition, the digital alloy barrier layer further has a function of being equivalent to the AlGaN barrier layer, that is, the digital alloy barrier layer and the AlGaN barrier layer together form the composite barrier layer, which is configured to generate a polarization effect with the channel layer, so that 2DEG is generated between the composite barrier layer and the channel layer. In addition, a growth rate of the digital alloy barrier layer is much lower than that of the AlGaN barrier layer. Therefore, the digital alloy barrier layer and the AlGaN barrier layer are combined to prevent the Mg ions from diffusing, while effectively improving production efficiency of products and reducing production costs of products. A growth method of the digital alloy barrier layer generates extremely small stress under a same proportion of a quantity of Al atoms, thereby avoiding an inverse piezoelectric effect caused by stress in a high-temperature and high-power working condition.

The digital alloy barrier layer is disposed between the doping layer and the AlGaN barrier layer. That is, the digital alloy barrier layer is closer to the doping layer than the AlGaN barrier layer. Because the digital alloy barrier layer is an atomic layer formed by a simple substance or a compound, compared with the AlGaN barrier layer formed by a mixture, the digital alloy barrier layer can more effectively prevent the Mg ions of the doping layer from diffusing. Therefore, disposing the digital alloy barrier layer close to the doping layer can more effectively prevent the Mg ions doped in the doping layer from diffusing to the composite barrier layer and the channel layer, thereby avoiding an increase in the on resistance, and ensuring the electrical performance of the semiconductor epitaxial structure. Certainly, in other embodiments, the AlGaN barrier layer is connected between the doping layer and the digital alloy barrier layer.

In an implementation, the digital alloy barrier layer is a laminated layer formed by 1 to 10 periodic AlN layers/GaN layers. That is, the AlN layer and the GaN layer are periodically arranged to form the digital alloy barrier layer, so that an arrangement manner of the digital alloy barrier layer is more regular, so as to better prevent the Mg ions doped in the doping layer from diffusing in the composite barrier layer and the channel layer, thereby avoiding an increase in the on resistance, and ensuring the electrical performance of the semiconductor epitaxial structure. In addition, the growth rate of the digital alloy barrier layer is much lower than that of the AlGaN barrier layer. Therefore, the digital alloy barrier layer is limited to be a laminated layer formed by 1 to 10 periodic AlN layers/GaN layers, so as to prevent the Mg ions from diffusing, while effectively improving the production efficiency of products and reducing the production costs of products.

The thickness of the digital alloy barrier layer is from 1 nm to 10 nm. With this thickness, the digital alloy barrier layer is better combined with the AlGaN barrier layer, thereby ensuring electrical performance of the digital alloy barrier layer and the AlGaN barrier layer. In addition, the thickness of the digital alloy barrier layer is from 1 nm to 10 nm, so as to prevent the Mg ions from diffusing, while effectively improving the production efficiency of products and reducing the production costs of products.

In an implementation, a thickness of the AlGaN barrier layer is from 2 nm to 40 nm, so as to avoid a relaxation phenomenon caused by an excessively large thickness of the AlGaN barrier layer, which affects the electrical performance of the semiconductor epitaxial structure.

In an implementation, a proportion of a quantity of Al atoms in the periodic AlN layer/GaN layer in the digital alloy barrier layer is 10% to 50%. The proportion of the quantity of Al atoms in the periodic AlN layer/GaN layer being 10% to 50% can effectively prevent the Mg ions from diffusing, further avoid an electric leakage phenomenon caused by an excessive high proportion of the quantity of Al atoms in the digital alloy barrier layer, and ensure the electrical performance of the semiconductor epitaxial structure.

In an implementation, a ratio of a thickness of the AlN layer to that of the GaN layer in the periodic AlN layer/GaN layer is m:n, where m is a positive integer less than or equal to 3, and n is a positive integer less than or equal to 10. That is, in this embodiment, the proportion of the quantity of Al atoms in the periodic AlN layer/GaN layer is controlled by controlling the ratio of the thickness of the AlN layer to that of the GaN layer in the periodic AlN layer/GaN layer.

In an implementation, the ratio of the thickness of the AlN layer to that of the GaN layer in the periodic AlN layer/GaN layer is 1:3, so as to ensure that the digital alloy barrier layer prevents the Mg ions from diffusing, while effectively improving the production efficiency of products and reducing the production costs of products.

In an implementation, a proportion of a quantity of Al atoms in the digital alloy barrier layer is greater than a proportion of a quantity of Al atoms in the AlGaN barrier layer. That is, the proportion of the quantity of Al atoms in the digital alloy barrier layer that is close to the doping layer is higher, so as to better prevent the Mg ions from diffusing. Certainly, in other embodiments, the proportion of the quantity of Al atoms in the digital alloy barrier layer may alternatively be less than or equal to the proportion of the quantity of Al atoms in the AlGaN barrier layer.

In an implementation, there are two digital alloy barrier layers, the two digital alloy barrier layers are respectively disposed on two sides of the AlGaN barrier layer, and the proportion of quantity of Al atoms in the digital alloy barrier layer is greater than the proportion of the quantity of Al atoms in the AlGaN barrier layer. That is, the digital alloy barrier layer that well prevents the Mg ions from diffusing is disposed on each of the two sides of the AlGaN barrier layer, so as to effectively prevent the Mg ions from diffusing to the AlGaN barrier layer. Even if a few Mg ions diffuse to the AlGaN barrier layer, they may further be prevented by the digital alloy barrier layer on the other side, so as to prevent the Mg ions from diffusing to the channel layer through the AlGaN barrier layer, thereby avoiding an increase in the on resistance, and ensuring the electrical performance of the semiconductor epitaxial structure. Certainly, in other embodiments, the proportion of the quantity of Al atoms in the digital alloy barrier layer may alternatively be less than or equal to the proportion of the quantity of Al atoms in the AlGaN barrier layer.

In an implementation, the semiconductor epitaxial structure further includes an insertion layer, and two opposite surfaces of the insertion layer are respectively connected to the AlGaN barrier layer and the channel layer. In this embodiment, the insertion layer is an AlN layer, a band gap of the insertion layer is wider, and a polarization effect of the channel layer is enhanced, which can increase the density of the 2DEG, and also has a function of buffering stress, that is, a function of alleviating a lattice mismatch between the composite barrier layer and the channel layer.

In an implementation, the semiconductor epitaxial structure further includes a substrate, and the substrate is located on a side of the channel layer that faces away from the composite barrier layer. In this embodiment, a material of the substrate is silicon. Certainly, in other embodiments, the substrate may alternatively be made of other substrate materials, such as sapphire, gallium nitride, silicon carbide, and diamond. The substrate is configured to carry a layer structure such as the channel layer, the composite barrier layer, and the doping layer.

In an implementation, the semiconductor epitaxial structure further includes a buffer layer, and the buffer layer is disposed on a surface of the channel layer that faces away from the composite barrier layer. In this embodiment, a material of the buffer layer is AlGaN. Certainly, in other embodiments, the buffer layer may alternatively be made of materials such as AlN and GaN. The buffer layer is configured to buffer an action of a force between the channel layer and a related layer structure.

In an implementation, the semiconductor epitaxial structure further includes a nucleation layer, and the nucleation layer is disposed on a surface of the buffer layer that faces away from the channel layer. In this embodiment, a material of the nucleation layer is AlN, so as to alleviate an action of stress caused by a lattice mismatch between materials.

The semiconductor device in this application includes the foregoing semiconductor epitaxial structure. The semiconductor device that includes the foregoing semiconductor epitaxial structure can effectively avoid an increase in on resistance caused by Mg ions diffusing from a p-GaN layer to a barrier layer and a channel layer, thereby further improving power density of the semiconductor device and achieving better electrical performance.

In this application, the composite barrier layer is disposed between the doping layer and the channel layer, and the digital alloy barrier layer in the composite barrier layer includes one or more AlN layers, and is a laminated atomic layer formed by a compound. In other words, in this application, the digital alloy barrier layer that includes one or more AlN layers is disposed between the doping layer and the channel layer, which can effectively prevent the Mg ions doped in the doping layer from diffusing to the composite barrier layer and the channel layer, thereby avoiding an increase in the on resistance, and further ensuring the electrical performance of the semiconductor epitaxial structure.

### BRIEF DESCRIPTION OF DRAWINGS

To describe technical solutions in embodiments of this application or in the background more clearly, the following describes the accompanying drawings for describing embodiments of this application or the background.
FIG. 1 is a schematic diagram of a structure of a semiconductor epitaxial structure according to an embodiment of this application;
FIG. 2 is a schematic diagram of a structure of a digital alloy barrier layer in the semiconductor epitaxial structure according to FIG. 1;
FIG. 3 is a schematic diagram of a structure of a specific arrangement of the digital alloy barrier layer according to FIG. 2;
FIG. 4 is a schematic diagram of a structure of a specific arrangement of an AlGaN barrier layer according to FIG. 1;
FIG. 5 is another schematic diagram of a structure of a semiconductor epitaxial structure;
FIG. 6 is still another schematic diagram of a structure of a semiconductor epitaxial structure;
FIG. 7 is still another schematic diagram of a structure of a semiconductor epitaxial structure; and
FIG. 8 is yet another schematic diagram of a structure of a semiconductor epitaxial structure.

### DESCRIPTION OF EMBODIMENTS

The following describes embodiments of this application with reference to the accompanying drawings in embodiments of this application.

A conventional HEMT is mostly a D-mode structure, that is, a depletion-mode HEMT without a p-GaN layer. That is, a barrier layer is disposed on a channel layer of the depletion-mode HEMT, and 2DEG is generated between the channel layer and the barrier layer by a polarization effect. The barrier layer is designed to increase density and mobility of the 2DEG. The barrier layer mainly uses an AlGaN barrier layer, and a digital alloy is rarely used as the barrier layer because of a low growth rate and the like. However, a commercial HEMT structure has to be an E-mode structure, that is, an enhancement-mode HEMT, which is not dangerous compared with the depletion-mode HEMT and has low static power consumption. One of main implementations of the enhancement-mode HEMT is to adjust a threshold voltage by adding a layer of p-GaN to the barrier layer. That is, the enhancement-mode HEMT includes a channel layer, a barrier layer, and a p-GaN layer that are sequentially disposed in a laminated manner, and the p-GaN layer is formed by doping Mg ions. A contradiction point is that a hole concentration needs to be increased by increasing a Mg ion concentration in the p-GaN layer to implement a positive drift of the threshold voltage. The barrier layer mainly uses the AlGaN barrier layer, the AlGaN barrier layer has a poor effect on preventing diffusion of Mg ions in the p-GaN layer, and an excessively high concentration of the Mg ions may diffuse to the channel layer through the AlGaN barrier layer, which causes an increase in sheet resistance (Rsheet) and on resistance (Ron) of the channel layer, thereby further limiting power density of the HEMT, and affecting electrical performance of the HEMT.

For this reason, an embodiment of this application provides a semiconductor device, which solves a problem that diffusion of Mg ions in a p-GaN layer causes an increase in sheet resistance (Rsheet) and on resistance (Ron) of a channel layer, which further limits power density of a HEMT and affects electrical performance of the HEMT. The semiconductor device effectively prevents the Mg ions from diffusing, and uses a composite structure of a digital alloy barrier and a conventional AlGaN barrier to decrease a growth time and reduce costs.

The semiconductor device includes, but is not limited to, a power electronic device such as an HEMT, a heterogeneous structure that generates 2DEG, and a radio frequency device. This application is specifically described by using an example in which the semiconductor device is an HEMT. The semiconductor device in this application includes a semiconductor epitaxial structure. The semiconductor device that includes the semiconductor epitaxial structure can effectively avoid an increase in the on resistance caused by the Mg ions diffusing from the p-GaN layer to the barrier layer and the channel layer, thereby further improving power density and achieving excellent electrical performance.

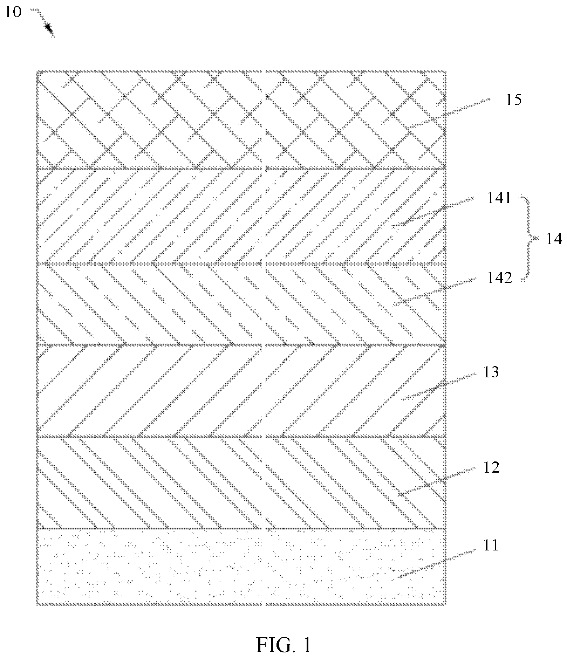

FIG. 1 is a schematic diagram of a structure of a semiconductor epitaxial structure according to an embodiment of this application. FIG. 1 is a first embodiment of a semiconductor epitaxial structure 10.

The semiconductor epitaxial structure 10 in this application includes a substrate 11, a buffer layer 12, a channel layer 13, a composite barrier layer 14, and a doping layer 15. The doping layer 15 is disposed on the composite barrier layer 14, the channel layer 13 is located on a side of the composite barrier layer 14 that faces away from the doping layer 15, the substrate 11 is located on a side of the channel layer 13 that faces away from the composite barrier layer 14, the buffer layer 12 is located between the substrate 11 and the channel layer 13, the composite barrier layer 14 includes a digital alloy barrier layer 141 and an AlGaN barrier layer 142 that are disposed in a laminated manner, and the digital alloy barrier layer 141 may include one or more AlN layers 1411.

In the semiconductor epitaxial structure 10 according to this application, the composite barrier layer 14 is disposed between the doping layer 15 and the channel layer 13, and the digital alloy barrier layer 141 in the composite barrier layer 14 may include one or more AlN layers 1411, which is a laminated atomic layer formed by a compound. In other words, in this application, the digital alloy barrier layer 141 that includes one or more AlN layers 1411 is disposed between the doping layer 15 and the channel layer 13, which can effectively prevent Mg ions doped in the doping layer 15 from diffusing to the composite barrier layer 14 and the channel layer 13, thereby avoiding an increase in on resistance and ensuring electrical performance of the semiconductor epitaxial structure 10. In addition, the digital alloy barrier layer 141 further has a function of being equivalent to the AlGaN barrier layer 142, that is, the digital alloy barrier layer 141 and the AlGaN barrier layer 142 together form the composite barrier layer 14, which is configured to generate a polarization effect with the channel layer 13, so that 2DEG is generated between the composite barrier layer 14 and the channel layer 13. In addition, a growth rate of the digital alloy barrier layer 141 is much lower than that of the AlGaN barrier layer 142. Therefore, the digital alloy barrier layer 141 and the AlGaN barrier layer 142 are combined to prevent the Mg ions from diffusing, while effectively improving production efficiency of products and reducing production costs of products. A growth method of the digital alloy barrier layer 141 generates extremely small stress under a same proportion of a quantity of Al atoms, thereby avoiding an inverse piezoelectric effect caused by stress in a high-temperature and high-power working condition.

In this embodiment, a material of the substrate 11 is silicon. Certainly, in other embodiments, the substrate 11 may be made of other substrate materials such as sapphire, gallium nitride, silicon carbide, and diamond. The substrate 11 is configured to carry a layer structure such as the buffer layer 12, the channel layer 13, the composite barrier layer 14 and the doping layer 15.

The buffer layer 12 is disposed on a surface of the substrate 11 that faces the channel layer 13, and a material of the buffer layer 12 is AlGaN. Certainly, in other embodiments, the buffer layer 12 may alternatively be made of materials such as AlN and GaN. A thickness of the buffer layer 12 is from 0.5 µm to 10 µm, and the buffer layer 12 is configured to buffer an action of a force between the substrate 11 and the channel layer 13.

The channel layer 13 is connected to a surface of the buffer layer 12 that faces away from the substrate 11, and a material of the channel layer 13 is GaN. Certainly, in other embodiments, the channel layer 13 may alternatively be made of materials such as AlGaN and InGaN. A thickness of the channel layer 13 is from 0.02 µm to 1 µm, and the channel layer 13 and the composite barrier layer 14 function to generate 2DEG.

In this embodiment, the digital alloy barrier layer 141 is disposed between the doping layer 15 and the AlGaN barrier layer 142, and the AlGaN barrier layer 142 is disposed on a surface of the channel layer 13 that faces away from the buffer layer 12. That is, the channel layer 13, AlGaN barrier layer 142, the digital alloy barrier layer 141, and the doping layer 15 are sequentially disposed in a laminated manner. Two opposite surfaces of the digital alloy barrier layer 141 are respectively connected to the doping layer 15 and the AlGaN barrier layer 142, and the digital alloy barrier layer 141 is closer to the doping layer 15 than the AlGaN barrier layer 142. Because the digital alloy barrier layer 141 is an atomic layer formed by a simple substance or a compound, compared with the AlGaN barrier layer 142 formed by a mixture, the digital alloy barrier layer 141 can more effectively prevent the Mg ions of the doping layer 15 from diffusing. Therefore, disposing the digital alloy barrier layer 141 close to the doping layer 15 can more effectively prevent the Mg ions doped in the doping layer 15 from diffusing to the composite barrier layer 14 and the channel layer 13, thereby avoiding an increase in the on resistance, and ensuring the electrical performance of the semiconductor epitaxial structure 10. Certainly, in other embodiments, the AlGaN barrier layer 142 is connected between the doping layer 15 and the digital alloy barrier layer 141. That is, exchanging a disposing position of the digital alloy barrier layer 141 and that of the AlGaN barrier layer 142 alternatively can effectively prevent the Mg ions from massively diffusing to the composite barrier layer 14 and the channel layer 13, thereby avoiding an increase in the on resistance, and ensuring the electrical performance of the semiconductor epitaxial structure 10.

In this embodiment, the doping layer 15 is disposed on a surface of the digital alloy barrier layer 141 that faces away from the AlGaN barrier layer 142, and the doping layer 15 is a P-type doping layer 15 formed by a GaN material and doping Mg ions. Certainly, in other embodiments, a surface of the doping layer 15 that faces the digital alloy barrier layer 141 is laminated with a GaN layer 1412 in the digital alloy barrier layer 141.

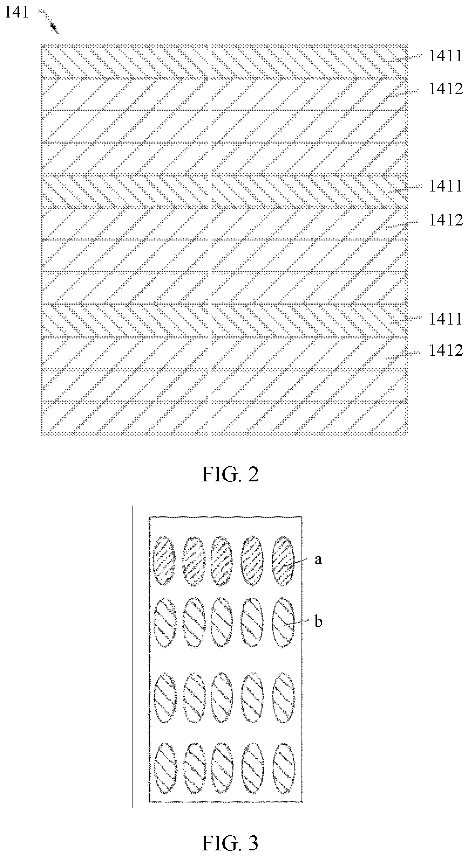

Referring to FIG. 2 and FIG. 3, FIG. 2 is a schematic diagram of a structure of a digital alloy barrier layer in the semiconductor epitaxial structure according to FIG. 1. FIG. 3 is a schematic diagram of a structure of a specific arrangement of the digital alloy barrier layer according to FIG. 2.

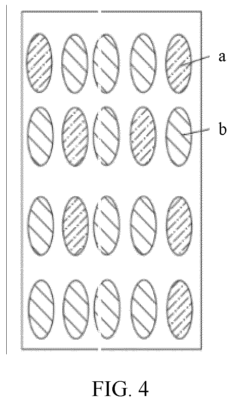

Specifically, in a nitride material, an impurity diffusion suppression ability of an AlN material is much stronger than that of a GaN material. In this embodiment, the digital alloy barrier layer 141 is a laminated layer formed by three periodic AlN layers 1411/GaN layers 1412. It may be understood that the periodic AlN layer 1411/GaN layer 1412 is formed by one AlN layer 1411 and one GaN layer 1412, and the three periodic AlN layers 1411/GaN layers 1412 are formed by one AlN layer 1411, one GaN layer, one AlN layer 1411, one GaN layer, one AlN layer 1411 and one GaN layer in a laminated manner. In other words, the three periodic AlN layers 1411/GaN layers 1412 are formed by three AlN layers 1411 and three GaN layers that are formed in a sequentially and alternately laminated manner. The AlN layer 1411 in the digital alloy barrier layer 141 and a surface of the doping layer 15 that faces the digital alloy barrier layer 141 are laminated, which helps to prevent the Mg ions from diffusing. In this embodiment, the AlN layer 1411 and the GaN layer 1412 are periodically arranged to form the digital alloy barrier layer 141, so that compounds AlNa and GaNb of the digital alloy barrier layer 141 are separately arranged in rows regularly. The compound AlNa in the digital alloy barrier layer 141 is arranged more regularly, compared with an irregular arrangement of compounds AlNa and GaNb in a mixture AlGaN (refer to FIG. 4), which can better prevent the Mg ions doped in the doping layer 15 from diffusing to the composite barrier layer 14 and the channel layer 13, thereby avoiding an increase in the on resistance, and ensuring the electrical performance of the semiconductor epitaxial structure 10. In addition, the growth rate of the digital alloy barrier layer 141 is much lower than that of the AlGaN barrier layer 142, that is, forming a laminated layer of more periodic AlN layers 1411/GaN layers 1412 consumes more production time. Therefore, the digital alloy barrier layer 141 is limited to a laminated layer formed by three periodic AlN layers 1411/GaN layers 1412, that is, the digital alloy barrier layer 141 only needs to be able to prevent the Mg ions from diffusing, so as to prevent the Mg ions from diffusing, while effectively improving the production efficiency of products and reducing the production costs of products. Certainly, in other embodiments, the digital alloy barrier layer 141 is a laminated layer formed by 1 to 10 periodic AlN layers 1411/GaN layers 1412. Alternatively, GaN in the digital alloy barrier layer 141 may be replaced by another compound, for example, the digital alloy barrier layer 141 is a laminated layer formed by an InN layer and an AlN layer.

A thickness of the digital alloy barrier layer 141 in this embodiment is 6 nm. Specifically, with this thickness, the digital alloy barrier layer 141 can be better combined with the AlGaN barrier layer 142, thereby ensuring electrical performance of the digital alloy barrier layer 141 and the AlGaN barrier layer 142. In addition, the thickness of the digital alloy barrier layer 141 is 6 nm, so as to prevent the Mg ions from diffusing, while effectively improving the production efficiency of products and reducing the production costs of products. Certainly, in other embodiments, the thickness of the digital alloy barrier layer 141 may be from 1 nm to 10 nm.

A proportion of a quantity of Al atoms in the periodic AlN layer 1411/GaN layer 1412 in the digital alloy barrier layer 141 is 25%, that is, the proportion of the quantity of Al atoms in the periodic AlN layer 1411/GaN layer 1412 to a quantity of all atoms is 25%. In this embodiment, a thickness of a single GaN layer 1412 and AlN layer 1411 in the periodic AlN layer 1411/GaN layer 1412 is about 0.5 nm, and a ratio of a thickness of the AlN layer 1411 to that of the GaN layer 1412 in the periodic AlN layer 1411/GaN layer 1412 is 1:3. Three GaN layers 1412 and one AlN layer 1411 are sequentially disposed in a laminated manner, so that the proportion of the quantity of Al atoms in the periodic AlN layer 1411/GaN layer 1412 is 25%. Certainly, the periodic AlN layer 1411/GaN layer 1412 may alternatively be one AlN layer 1411 and three GaN layers 1412 that are sequentially disposed in a laminated manner, or one AlN layer 1411 is located between any two layers of the three GaN layers 1412. The proportion of the quantity of Al atoms in the periodic AlN layer 1411/GaN layer 1412 being 25% can effectively prevent the Mg ions from diffusing, avoid an electric leakage phenomenon caused by an excessively high proportion of a quantity of Al atoms in the digital alloy barrier layer 141, and ensure the electrical performance of the semiconductor epitaxial structure 10. In addition, the digital alloy barrier layer 141 can prevent the Mg ions from diffusing, while effectively improving the production efficiency of products and reducing the production costs of products. Certainly, in other embodiments, the proportion of the quantity of Al atoms in the periodic AlN layer 1411/GaN layer 1412 may optionally be 10% to 50%. For example, the thickness of the single GaN layer 1412 and AlN layer 1411 is about 0.5 nm, and the ratio of the thickness of the AlN layer 1411 to that of the GaN layer 1412 in the periodic AlN layer 1411/GaN layer 1412 is m:n, where m is a positive integer less than or equal to 3, and n is a positive integer less than or equal to 10. That is, in this embodiment, the proportion of the quantity of Al atoms in the periodic AlN layer 1411/GaN layer 1412 is controlled to be 10% to 50% by controlling the ratio of the thickness of the AlN layer 1411 to that of the GaN layer 1412 in the periodic AlN layer 1411/GaN layer 1412. This can effectively prevent the Mg ions from diffusing, avoid an electric leakage phenomenon caused by the excessively high proportion of a quantity of Al atoms in the digital alloy barrier layer 141, and ensure the electrical performance of the semiconductor epitaxial structure 10.

As shown in FIG. 2, a thickness of the AlGaN barrier layer 142 is from 2 nm to 40 nm, so as to avoid a relaxation phenomenon caused by an excessively large thickness of the AlGaN barrier layer 142. That is, deformation (for example, a surface bending phenomenon) caused by an action of stress generated by the excessively large thickness of the AlGaN barrier layer 142 causes a failure of fitting between the AlGaN barrier layer 142 and a layer laminated with the AlGaN barrier layer 142, which affects the electrical performance of the semiconductor epitaxial structure 10. The proportion of the quantity of Al atoms in the AlGaN barrier layer 142 is 25%. Certainly, in other embodiments, the proportion of the quantity of Al atoms in the AlGaN barrier layer 142 may alternatively be 5% to 30%, and may be specifically adjusted based on the proportion of the quantity of Al atoms in the digital alloy barrier layer 141, so that the entire composite barrier layer 14 meets an electrical performance requirement.

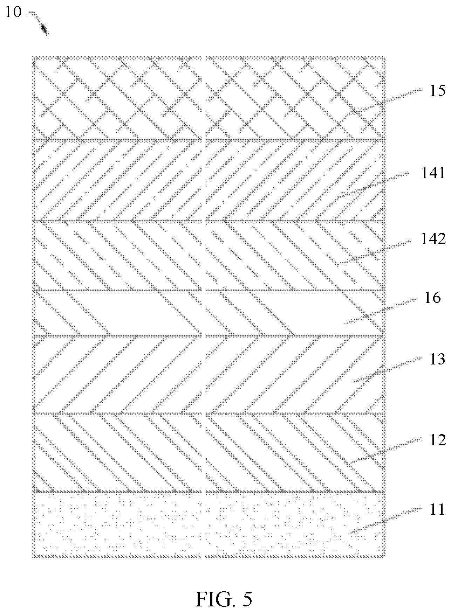

FIG. 5 is another schematic diagram of a structure of the semiconductor epitaxial structure. FIG. 5 is a second embodiment of the semiconductor epitaxial structure 10. The semiconductor epitaxial structure 10 in this embodiment includes a substrate 11, a buffer layer 12, a channel layer 13, a composite barrier layer 14, and a doping layer 15. The substrate 11, the buffer layer 12, and the channel layer 13 are sequentially disposed in a laminated manner, the composite barrier layer 14 is disposed on a side of the channel layer 13 that faces away from the buffer layer 12, and the doping layer 15 is disposed on a surface of the composite barrier layer 14 that faces away from the channel layer 13. The composite barrier layer 14 includes a digital alloy barrier layer 141 and an AlGaN barrier layer 142 that are disposed in a laminated manner, and the digital alloy barrier layer 141 is disposed close to the doping layer 15. The semiconductor epitaxial structure 10 in this embodiment further includes an insertion layer 16, and two opposite surfaces of the insertion layer 16 are respectively connected to the AlGaN barrier layer 142 and the channel layer 13. In this embodiments, the insertion layer 16 is an AlN layer, and a larger band gap of the insertion layer 16 (a unit is electron-volt (ev), and in order that a bound electron becomes a free electron or electron hole, enough energy needs to be obtained to transition from a valence band to a conduction band, and a minimum value of this energy is a band gap) enhances a polarization effect of the channel layer 13, which may increase a concentration of 2DEG, and also have a function of buffering stress, that is, a function of alleviating a lattice mismatch between the composite barrier layer 14 and the channel layer 13. Certainly, in other embodiments, the semiconductor epitaxial structure 10 may alternatively include a nucleation layer 17.

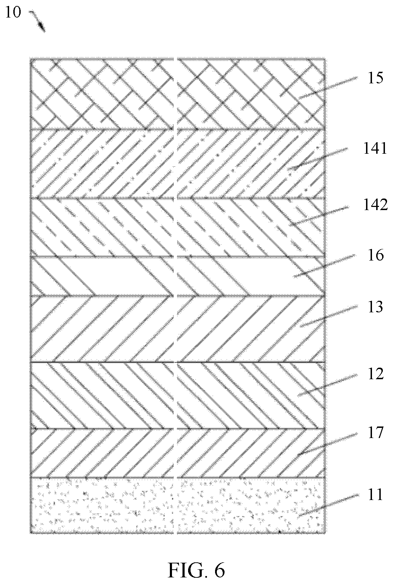

FIG. 6 is still another schematic diagram of a structure of the semiconductor epitaxial structure. FIG. 6 is a third embodiment of the semiconductor epitaxial structure 10. The semiconductor epitaxial structure 10 in this embodiment includes a substrate 11, a buffer layer 12, a channel layer 13, a composite barrier layer 14, and a doping layer 15. The buffer layer 12 and the channel layer 13 are disposed in a laminated manner, the substrate is disposed on a side of the buffer layer 12 that faces away from the channel layer 13, the composite barrier layer 14 is disposed on a side of channel layer 13 that faces away from the buffer layer 12, and the doping layer 15 is disposed on a surface of the composite barrier layer 14 that faces away from the channel layer 13. The composite barrier layer 14 includes a digital alloy barrier layer 141 and an AlGaN barrier layer 142 that are disposed in a laminated manner, and the digital alloy barrier layer 141 is disposed close to the doping layer 15. An insertion layer 16 is disposed between the composite barrier layer 14 and the channel layer 13. The semiconductor epitaxial structure 10 in this embodiment further includes a nucleation layer 17, and the nucleation layer 17 is disposed on a surface of the substrate 11 that faces the buffer layer 12. In this embodiment, a material of the nucleation layer 17 is AlN, so as to alleviate an action of stress caused by a lattice mismatch between materials. Certainly, in other embodiments, the insertion layer 16 is not disposed between the composite barrier layer 14 and the channel layer 13, that is, the composite barrier layer 14 is directly connected to the channel layer 13.

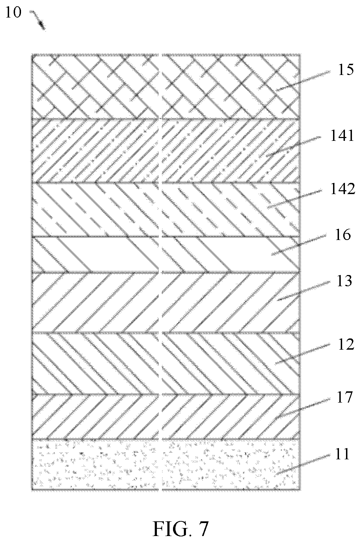

FIG. 7 is still another schematic diagram of a structure of the semiconductor epitaxial structure. FIG. 7 is a fourth embodiment of the semiconductor epitaxial structure 10. The semiconductor epitaxial structure 10 in this embodiment includes a substrate 11, a nucleation layer 17, a buffer layer 12, a channel layer 13, an insertion layer 16, a composite barrier layer 14, and a doping layer 15 that are sequentially disposed in a laminated manner. The composite barrier layer 14 includes a digital alloy barrier layer 141 and an AlGaN barrier layer 142 that are disposed in a laminated manner, and the digital alloy barrier layer 141 is disposed close to the doping layer 15. In this embodiment, a proportion of a quantity of Al atoms in the digital alloy barrier layer 141 is greater than a proportion of a quantity of Al atoms in the AlGaN barrier layer 142. Specifically, the proportion of the quantity of Al atoms in the digital alloy barrier layer 141 and the proportion of the quantity of Al atoms in the AlGaN barrier layer 142 may be disposed based on a specific requirement. That is, the proportion of the quantity of Al atoms in the digital alloy barrier layer 141 that is close to the doping layer 15 is higher, so as to better prevent Mg ions from diffusing. Certainly, in other embodiments, the proportion of the quantity of Al atoms in the digital alloy barrier layer 141 may alternatively be less than or equal to the proportion of the quantity of Al atoms in the AlGaN barrier layer 142. The nucleation layer 17 and/or the insertion layer 16 may alternatively not be disposed in the semiconductor epitaxial structure 10, that is, the substrate 11, the buffer layer 12, the channel layer 13, the insertion layer 16, the composite barrier layer 14, and the doping layer 15 are sequentially disposed in a laminated manner, or the substrate 11, the nucleation layer 17, the buffer layer 12, the channel layer 13, the composite barrier layer 14 and the doping layer 15 are sequentially disposed in a laminated manner, or the substrate 11, the buffer layer 12, the channel layer 13, the composite barrier layer 14, and the doping layer 15 are sequentially disposed in a laminated manner.

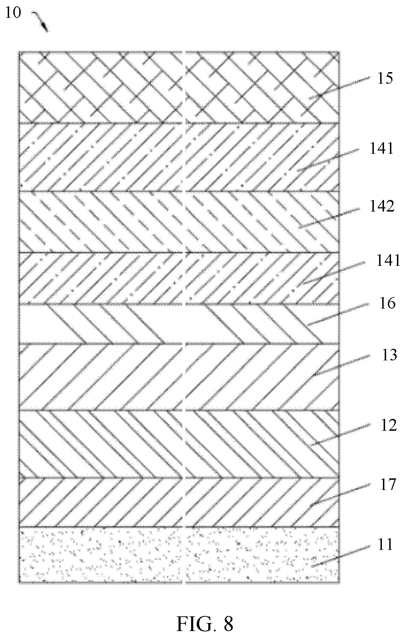

FIG. 8 is yet another schematic diagram of a structure of the semiconductor epitaxial structure. FIG. 8 is a fifth embodiment of the semiconductor epitaxial structure 10. The semiconductor epitaxial structure 10 in this embodiment includes a substrate 11, a nucleation layer 17, a buffer layer 12, a channel layer 13, an insertion layer 16, a composite barrier layer 14, and a doping layer 15 that are sequentially disposed in a laminated manner. The composite barrier layer 14 includes a digital alloy barrier layer 141 and an AlGaN barrier layer 142 that are disposed in a laminated manner, and the digital alloy barrier layer 141 is disposed close to the doping layer 15. There are two digital alloy barrier layers 141 in this embodiment, the two digital alloy barrier layers 141 are respectively disposed on two sides of the AlGaN barrier layer 142, that is, one digital alloy barrier layer 141 is added between the AlGaN barrier layer 142 and the insertion layer 16. A proportion of a quantity of Al atoms in the digital alloy barrier layer 141 is greater than a proportion of a quantity of Al atoms in the AlGaN barrier layer 142. Thicknesses of the two digital alloy barrier layers 141 in this embodiment may be the same or different, that is, the digital alloy barrier layer 141 that effectively prevents Mg ions from diffusing is disposed on each of the two sides of the AlGaN barrier layer 142, which can effectively prevent the Mg ions from diffusing to the AlGaN barrier layer 142. Even if a few Mg ions diffuse to the AlGaN barrier layer 142, they may be prevented by the digital alloy barrier layer 141 on the other side, so as to prevent the Mg ions from diffusing to the channel layer 13 through the AlGaN barrier layer 142, thereby avoiding an increase in on resistance, and effectively ensuring electrical performance of the semiconductor epitaxial structure 10. Certainly, in other embodiments, the proportion of the quantity of Al atoms in the digital alloy barrier layer 141 may alternatively be less than or equal to the proportion of the quantity of Al atoms of the Al in the AlGaN barrier layer 142. There may alternatively be two AlGaN barrier layers 142, which are respectively disposed on two sides of the digital alloy barrier layer 141. The nucleation layer 17 and/or the insertion layer 16 may alternatively not be disposed in the semiconductor epitaxial structure 10, that is, the substrate 11, the buffer layer 12, the channel layer 13, the insertion layer 16, the composite barrier layer 14, and the doping layer 15 are sequentially disposed in a laminated manner, or the substrate 11, the nucleation layer 17, the buffer layer 12, the channel layer 13, the composite barrier layer 14 and the doping layer 15 are sequentially disposed in a laminated manner, or the substrate 11, the buffer layer 12, the channel layer 13, the composite barrier layer 14, and the doping layer 15 are sequentially disposed in a laminated manner.

In this application, the composite barrier layer 14 is disposed between the doping layer 15 and the channel layer 13, and the digital alloy barrier layer 141 in the composite barrier layer 14 includes one or more AlN layers 1411, which is a laminated atomic layer formed by a compound. In other words, in this application, the digital alloy barrier layer 141 including one or more AlN layers 1411 is disposed between the doping layer 15 and the channel layer 13, which can effectively prevent the Mg ions doped in the doping layer 15 from diffusing to the composite barrier layer 14 and the channel layer 13, thereby avoiding an increase in the on resistance and ensuring the electrical performance of the semiconductor epitaxial structure 10. In addition, the digital alloy barrier layer 141 further has the function of being equivalent to the AlGaN barrier layer 142, that is, the digital alloy barrier layer 141 and the AlGaN barrier layer 142 together form the composite barrier layer 14, which is configured to generate a polarization effect with the channel layer 13, so that 2DEG is generated between the composite barrier layer 14 and the channel layer 13. In addition, the growth rate of the digital alloy barrier layer 141 is much lower than that of the AlGaN barrier layer 142. Therefore, the digital alloy barrier 141 and the AlGaN barrier layer 142 are combined to prevent the Mg ions from diffusing, while effectively improving the production efficiency of products and reducing the production costs of products. The growth method of the digital alloy barrier layer 141 generates extremely small stress under a same proportion of the quantity of Al atoms, thereby avoiding an inverse piezoelectric effect caused by stress in a high-temperature and high-power working condition.

## Claims

1. A semiconductor epitaxial structure (10), comprising a channel layer (13), a composite barrier layer (14), and a doping layer (15), wherein the doping layer is disposed on the composite barrier layer, the channel layer is disposed on a side of the composite barrier layer that faces away from the doping layer, the composite barrier layer comprises a digital alloy barrier layer (141) and an AlGaN barrier layer (142) that are disposed in a laminated manner, and the digital alloy barrier layer is a laminated layer having a thickness between 1 nm and 10 nm formed by a periodic arrangement of 1 to 10 AlN layers (1411) and 1 to 10 GaN layers (1412), or 1 to 10 AlN layers (1411) and 1 to 10 InN layers, wherein the digital alloy barrier layer is disposed between the doping layer and the AlGaN barrier layer.

2. The semiconductor epitaxial structure according to claim 1, wherein a proportion of a quantity of Al atoms in the periodic arrangement of AlN and GaN layers of the digital alloy barrier layer is 10% to 50% relative to the total number of atoms in the periodic arrangement of AlN and GaN layers.

3. The semiconductor epitaxial structure according to claim 2, wherein a ratio of a thickness of the AlN layer to that of the GaN layer in the periodic arrangement of AlN and GaN layers is m:n, m is a positive integer less than or equal to 3, and n is a positive integer less than or equal to 10.

4. The semiconductor epitaxial structure according to claim 3, wherein the proportion of the quantity of Al atoms in the digital alloy barrier layer is greater than or equal to a proportion of a quantity of Al atoms in the AlGaN barrier layer.

5. The semiconductor epitaxial structure according to claim 3, wherein there are two digital alloy barrier layers, the two digital alloy barrier layers are respectively disposed on two sides of the AlGaN barrier layer, and the proportion of the quantity of Al atoms in the digital alloy barrier layer is greater than or equal to a proportion of a quantity of Al atoms in the AlGaN barrier layer.

6. The semiconductor epitaxial structure according to claim 1, wherein the semiconductor epitaxial structure further comprises an insertion layer (16), and two opposite surfaces of the insertion layer are respectively connected to the AlGaN barrier layer and the channel layer.

7. The semiconductor epitaxial structure according to claim 6, wherein the semiconductor epitaxial structure further comprises a substrate (11), and the substrate is disposed on a side of the channel layer that faces away from the composite barrier layer.

8. The semiconductor epitaxial structure according to claim 6 or 7, wherein the semiconductor epitaxial structure further comprises a buffer layer (12), and the buffer layer is disposed on a surface of the channel layer that faces away from the composite barrier layer.

9. The semiconductor epitaxial structure according to claim 8, wherein the semiconductor epitaxial structure further comprises a nucleation layer (17), and the nucleation layer is disposed on a surface of the buffer layer that faces away from the channel layer.

10. A semiconductor device, wherein the semiconductor device comprises the semiconductor epitaxial structure according to any one of claims 1 to 9.

## Patentansprüche

1. Halbleiter-Epitaxiestruktur (10), umfassend eine Kanalschicht (13), eine zusammengesetzte Sperrschicht (14) und eine Dotierungsschicht (15), wobei die Dotierungsschicht auf der zusammengesetzten Sperrschicht angeordnet ist, die Kanalschicht auf einer Seite der zusammengesetzten Sperrschicht angeordnet ist, die von der Dotierungsschicht abgewandt ist, die zusammengesetzte Sperrschicht eine Sperrschicht aus digitaler Legierung (141) und eine AlGaN-Sperrschicht (142) umfasst, die laminiert angeordnet sind, und die Sperrschicht aus digitaler Legierung eine laminierte Schicht mit einer Dicke zwischen 1 nm und 10 nm ist und durch eine periodische Anordnung von 1 bis 10 AlN-Schichten (1411) und 1 bis 10 GaN-Schichten (1412) oder 1 bis 10 AlN-Schichten (1411) und 1 bis 10 InN-Schichten gebildet ist, wobei die Sperrschicht aus digitaler Legierung zwischen der Dotierungsschicht und der AlGaN-Sperrschicht angeordnet ist.

2. Halbleiter-Epitaxiestruktur nach Anspruch 1, wobei ein Anteil einer Menge von Al-Atomen in der periodischen Anordnung von AlN- und GaN-Schichten der Sperrschicht aus digitaler Legierung 10 % bis 50 % relativ zu der Gesamtanzahl von Atomen in der periodischen Anordnung von AlN- und GaN-Schichten beträgt.

3. Halbleiter-Epitaxiestruktur nach Anspruch 2, wobei ein Verhältnis einer Dicke der AlN-Schicht zu der der GaN-Schicht in der periodischen Anordnung von AlN- und GaN-Schichten m:n beträgt, wobei m eine positive ganze Zahl kleiner oder gleich 3 ist und n eine positive ganze Zahl kleiner oder gleich 10 ist.

4. Halbleiter-Epitaxiestruktur nach Anspruch 3, wobei der Anteil der Menge von Al-Atomen in der Sperrschicht aus digitaler Legierung größer als oder gleich wie ein Anteil einer Menge von Al-Atomen in der AlGaN-Sperrschicht ist.

5. Halbleiter-Epitaxiestruktur nach Anspruch 3, wobei zwei Sperrschichten aus digitaler Legierung vorhanden sind, die zwei Sperrschichten aus digitaler Legierung jeweils auf zwei Seiten der AlGaN-Sperrschicht angeordnet sind und der Anteil der Menge von Al-Atomen in der Sperrschicht aus digitaler Legierung größer als oder gleich einem Anteil einer Menge von Al-Atomen in der AlGaN-Schicht ist.

6. Halbleiter-Epitaxiestruktur nach Anspruch 1, wobei die Halbleiter-Epitaxiestruktur ferner eine Einfügungsschicht (16) umfasst und zwei gegenüberliegende Oberflächen der Einfügungsschicht jeweils mit der AlGaN-Sperrschicht und der Kanalschicht verbunden sind.

7. Halbleiter-Epitaxiestruktur nach Anspruch 6, wobei die Halbleiter-Epitaxiestruktur ferner ein Substrat (11) umfasst und das Substrat auf einer Seite der Kanalschicht angeordnet ist, die von der zusammengesetzten Sperrschicht abgewandt ist.

8. Halbleiter-Epitaxiestruktur nach Anspruch 6 oder 7, wobei die Halbleiter-Epitaxiestruktur ferner eine Pufferschicht (12) umfasst und die Pufferschicht auf einer Oberfläche der Kanalschicht angeordnet ist, die von der zusammengesetzten Sperrschicht abgewandt ist.

9. Halbleiter-Epitaxiestruktur nach Anspruch 8, wobei die Halbleiter-Epitaxiestruktur ferner eine Keimbildungsschicht (17) umfasst und die Keimbildungsschicht auf einer Oberfläche der Pufferschicht angeordnet ist, die von der Kanalschicht abgewandt ist.

10. Halbleitervorrichtung, wobei die Halbleitervorrichtung die Halbleiter-Epitaxiestruktur nach einem der Ansprüche 1 bis 9 umfasst.

## Revendications

1. Structure épitaxiale semi-conductrice (10), comprenant une couche de canal (13), une couche barrière composite (14), et une couche de dopage (15), la couche de dopage étant disposée sur la couche barrière composite, la couche de canal étant disposée sur une face de la couche barrière composite opposée à la couche de dopage, la couche barrière composite comprenant une couche barrière d'alliage numérique (141) et une couche barrière d'AlGaN (142) qui sont disposées de manière stratifiée, et la couche barrière d'alliage numérique étant une couche stratifiée d'une épaisseur comprise entre 1 nm et 10 nm formée par un agencement périodique de 1 à 10 couches d'AlN (1411) et de 1 à 10 couches de GaN (1412), ou de 1 à 10 couches d'AlN (1411) et de 1 à 10 couches d'InN, la couche barrière d'alliage numérique étant disposée entre la couche de dopage et la couche barrière d'AlGaN.

2. Structure épitaxiale semi-conductrice selon la revendication 1, une proportion d'une quantité d'atomes d'Al dans l'agencement périodique des couches d'AlN et de GaN de la couche barrière d'alliage numérique étant de 10 % à 50 % par rapport au nombre total d'atomes dans l'agencement périodique des couches d'AIN et de GaN.

3. Structure épitaxiale semi-conductrice selon la revendication 2, un rapport entre une épaisseur de la couche d'AlN et celle de la couche de GaN dans l'agencement périodique des couches d'AlN et de GaN étant m:n, m étant un nombre entier positif inférieur ou égal à 3, et n étant un nombre entier positif inférieur ou égal à 10.

4. Structure épitaxiale semi-conductrice selon la revendication 3, la proportion de la quantité d'atomes d'Al dans la couche barrière d'alliage numérique étant supérieure ou égale à une proportion de la quantité d'atomes d'Al dans la couche barrière d'AlGaN.

5. Structure épitaxiale semi-conductrice selon la revendication 3, deux couches barrières d'alliage numérique étant présentes, les deux couches barrières d'alliage numérique étant respectivement disposées sur les deux côtés de la couche barrière d'AlGaN, et la proportion de la quantité d'atomes d'Al dans la couche barrière d'alliage numérique étant supérieure ou égale à une proportion d'une quantité d'atomes d'Al dans la couche barrière d'AlGaN.

6. Structure épitaxiale semi-conductrice selon la revendication 1, la structure épitaxiale semi-conductrice comprenant en outre une couche d'insertion (16), et deux surfaces opposées de la couche d'insertion étant respectivement reliées à la couche barrière d'AlGaN et à la couche de canal.

7. Structure épitaxiale semi-conductrice selon la revendication 6, la structure épitaxiale semi-conductrice comprenant en outre un substrat (11), et le substrat étant disposé sur une face de la couche de canal qui est opposée à la couche barrière composite.

8. Structure épitaxiale semi-conductrice selon la revendication 6 ou 7, la structure épitaxiale semi-conductrice comprenant en outre une couche tampon (12), et la couche tampon étant disposée sur une surface de la couche de canal qui est opposée à la couche barrière composite.

9. Structure épitaxiale semi-conductrice selon la revendication 8, la structure épitaxiale semi-conductrice comprenant en outre une couche de nucléation (17), et la couche de nucléation étant disposée sur une surface de la couche tampon qui est opposée à la couche de canal.

10. Dispositif semi-conducteur, le dispositif semi-conducteur comprenant la structure épitaxiale semi-conductrice selon l'une quelconque des revendications 1 à 9.
